# EUROPÄISCHE PATENTSCHRIFT

(11) **EP 3 139 183 B1**
(45) Veröffentlichungstag und Bekanntmachung des Hinweises auf die Patenterteilung: **09.08.2017**
(21) Anmeldenummer: 16002093.9
(22) Anmeldetag: 17.02.2014
(51) Int. Cl.: G01R 1/20, G01R 19/00, G01R 35/00

(54) **MESSWIDERSTAND UND ENTSPRECHENDES MESSVERFAHREN**
MEASUREMENT RESISTANCE AND CORRESPONDING MEASURING METHOD
RESISTANCE DE MESURE ET PROCEDE DE MESURE CORRESPONDANT

(30) Priorität: 05.04.2013 DE 102013005939
(43) Veröffentlichungstag der Anmeldung: 08.03.2017
(62) Teilanmeldung aus: 14705477.9
(73) Patentinhaber: Isabellenhütte Heusler GmbH & Co.KG, 35683 Dillenburg (DE)
(72) Erfinder: Hetzler, Ullrich, 35688 Dillenburg-Oberscheld (DE)
(74) Vertreter: v. Bezold & Partner Patentanwälte - PartG mbB

(56) Entgegenhaltungen:
- GB-A- 2 434 252
- JP-A- 2009 244 065
- US-A1- 2007 177 318
- US-B1- 6 181 234

## Beschreibung

Die Erfindung betrifft einen Messwiderstand, insbesondere einen niederohmigen Strommesswiderstand. Weiterhin betrifft die Erfindung ein entsprechendes Messverfahren.

Aus dem Stand der Technik (z.B. DE 42 43 349 A1) ist seit längerem die Strommessung mit niederohmigen Strommesswiderständen ("Shunts") gemäß der sogenannten Vierleitertechnik bekannt. Dabei wird der zu messende elektrische Strom in den niederohmigen Strommesswiderstand eingeleitet, wobei die Spannung gemessen wird, die über dem Widerstandselement des niederohmigen Strommesswiderstandes abfällt. Die gemessene elektrische Spannung ist dann entsprechend dem Ohmschen Gesetz ein Maß für den elektrischen Strom, der durch den Strommesswiderstand fließt.

Derartige Strommesswiderstände können beispielsweise plattenförmig ausgebildet sein, wie es beispielsweise in EP 0 605 800 A1 und DE 42 43 349 A1 beschrieben ist. Eine andere Bauform derartiger Strommesswiderstände als Koaxialwiderstand ist beispielsweise in WO 2007/068409 A1 und DE 10 2005 059 561 A1 beschrieben.

Die bekannten Strommesswiderstände sind jedoch hinsichtlich der Messgenauigkeit noch nicht vollständig befriedigend.

Ferner ist zum Stand der Technik hinzuweisen auf US 6 181 234 B1. Diese Druckschrift offenbart einen plattenförmigen niederohmigen Widerstand mit einem mittig angeordneten Widerstandsstreifen, der beispielsweise aus einer Nickel-Aluminium-Legierung bestehen kann. An den beiden gegenüber liegenden Seitenkanten des Widerstandsstreifens sind zwei ebenfalls plattenförmige Wärmeleitelemente angeschweißt, die beispielsweise aus Kupfer bestehen können und ausschließlich zur Pufferung und Ableitung von Verlustwärme dienen. An der Oberseite des Wärmeleitelements sind hierbei fünf Kontaktpaare nebeneinander ausgeformt. Eines dieser Kontaktpaare dient hierbei zur Messung der über dem Widerstandsstreifen abfallenden elektrischen Spannung, während die anderen Kontaktpaare zum Einleiten bzw. Ausleiten des elektrischen Stroms dienen, was eine Strommessung gemäß der bekannten Vierleitertechnik ermöglicht. Auch hierbei erfolgt die Messung der über dem Widerstand abfallenden elektrischen Spannung nur an einer bestimmten Stelle mittels eines einzigen Kontaktpaars. Weiterhin ist hierbei zu erwähnen, dass die plattenförmigen Wärmeleitelemente an den Seiten des Widerstandsstreifens selbst nicht zur elektrischen Kontaktierung dienen und dazu auch nicht geeignet sind. Dieser bekannte Widerstand weist also einen grundsätzlich anderen Aufbau auf und ist deshalb gattungsfremd.

Ferner ist zum Stand der Technik noch hinzuweisen auf DE 10 2006 039 722 A1 und DE 10 2012 211 749 A1. Diese Druckschriften offenbaren jedoch andere Typen von Widerständen und sind deshalb ebenfalls gattungsfremd.

Schließlich zum technischen Hintergrund der Erfindung auch hinzuweisen auf US 2007/177318 A1, JP 2009 244065 A, US 6 181 234 B1 und GB 2 434 252 A.

Der Erfindung liegt deshalb die Aufgabe zugrunde, die bekannten Messwiderstände entsprechend zu verbessern.

Diese Aufgabe wird durch einen erfindungsgemäßen Messwiderstand gemäß dem Hauptanspruch gelöst. Weiterhin umfasst die Erfindung ein entsprechendes Messverfahren gemäß dem Nebenanspruch.

Die Erfindung beruht auf der technisch-physikalischen Erkenntnis, dass die Stromdichte in dem Widerstandselement bei den bekannten Strommesswiderständen nicht exakt homogen und gleichgerichtet ist, so dass die Spannungsmesswerte an dem Messwiderstand von dem Ort der Messung abhängen, d.h. von der Positionierung der Spannungsmesskontakte. Beispielsweise werden diese störenden Inhomogenitäten der Stromdichte in dem Widerstandselement verursacht durch eine unsymmetrische Stromzuführung, Inhomogenitäten in Zuleitung, Anschlusskontakt und Widerstandsmaterial, Temperaturabhängigkeiten eines Kupfer-Vorwiderstands, Stromverdrängung und Einflüsse von Induktivität und Magnetfeldern. Bei der Berechnung des durch den Strommesswiderstand fließenden elektrischen Stroms entsprechend dem Ohmschen Gesetz aus dem Spannungsmesswert wird jedoch angenommen, dass der Spannungsmesswert exakt der Spannung entspricht, die über dem Widerstandselement des Strommesswiderstandes abfällt. Tatsächlich wird die Berechnung des durch den Strommesswiderstand fließenden elektrischen Stroms jedoch durch die vorstehend erwähnten Inhomogenitäten verfälscht.

Die Erfindung umfasst deshalb die allgemeine technische Lehre, die Inhomogenitäten der Stromdichte in dem Messwiderstand zu berücksichtigen und dadurch eine genauere Messung zu ermöglichen.

Der erfindungsgemäße Widerstand weist in Übereinstimmung mit dem eingangs beschriebenen herkömmlichen Strommesswiderstand vorzugsweise zwei Anschlussteile aus einem elektrisch leitfähigen Leitermaterial auf, um den elektrischen Strom in den Widerstand einzuleiten bzw. aus dem Widerstand abzuführen.

Bei dem Leitermaterial der beiden Anschlussteile handelt es sich vorzugsweise um Kupfer oder eine Kupferlegierung, da deren spezifischer elektrischer Widerstand äußerst gering ist. Die Erfindung ist jedoch hinsichtlich des Leitermaterials der Anschlussteile nicht auf Kupfer oder Kupferlegierungen beschränkt, sondern grundsätzlich auch mit anderen Leitermaterialien realisierbar, die einen hinreichend geringen spezifischen elektrischen Widerstand aufweisen. Vorzugsweise ist der spezifische elektrische Widerstand des Leitermaterials kleiner als 10⁻⁵ Ω·m, 10⁻⁶ Ω·m oder sogar kleiner als 10⁻⁷ Ω·m.

Darüber hinaus weist der erfindungsgemäße Widerstand in Übereinstimmung mit dem eingangs beschriebenen herkömmlichen Strommesswiderstand ein Widerstandselement auf, das im Stromflusspfad zwischen den beiden Anschlussteilen angeordnet ist, so dass der elektrische Strom durch das Widerstandselement fließt. Das Widerstandselement besteht hierbei aus einem niederohmigen Widerstandsmaterial, dessen spezifischer elektrischer Widerstand größer ist als der spezifische elektrische Widerstand des Leitermaterials der beiden Anschlussteile. Beispielsweise kann es sich bei dem Widerstandsmaterial des Widerstandselements um eine Nickellegierung handeln, wie beispielsweise Nickel-Chrom oder Kupfer-Nickel. Vorzugsweise wird als Widerstandsmaterial jedoch Cu84Ni4Mn12 (Manganin®) oder Cu91Mn7Sn2 (Zeranin® 30)eingesetzt.

Hierbei ist zu erwähnen, dass das Widerstandsmaterial vorzugsweise niederohmig ist und einen spezifischen elektrischen Widerstand aufweist, der vorzugsweise kleiner ist als 10⁻⁴ Ω·m, 10⁻⁵ Ω·m oder sogar kleiner als 10⁻⁶ Ω·m.

Ferner ist noch zu erwähnen, dass die Anschlussteile und/oder das Widerstandselement vorzugsweise plattenförmig sind, wobei auch eine gebogene Plattenform in Frage kommt, was an sich jedoch aus dem Stand der Technik bekannt ist.

Hierbei ist zu erwähnen, dass Strom und Spannung in dem Widerstandselement des Messwiderstands teilweise ein induktives Verhalten und teilweise ein kapazitives Verhalten zeigen. Ein kapazitives Verhalten von Strom und Spannung zeichnet sich dadurch aus, dass der Strom bei einem Wechselstrom der Spannung vorauseilt. Ein induktives Verhalten zeichnet sich dagegen dadurch aus, dass der Strom bei einem Wechselstrom der Spannung nacheilt. Bei einem plattenförmigen Strommesswiderstand verhalten sich Strom und Spannung in den seitlich außen liegenden Bereichen des Widerstandselements in der Regel kapazitiv, während sich Strom und Spannung in einem mittleren Bereich des Widerstandselements im Wesentlichen induktiv verhalten. Zwischen den kapazitiven Bereichen und den induktiven Bereichen des Widerstandselements befinden sich neutrale Punkte, in denen Strom und Spannung im Wesentlichen phasengleich sind und somit weder ein kapazitives Verhalten noch ein induktives Verhalten zeigen. Gemäß der Erfindung ist deshalb vorgesehen, dass ein Paar von Spannungsmesskontakten an dem Messwiderstand an einer Stelle angeordnet ist, die dem vorstehend erwähnten neutralen Punkt entspricht. Dies bedeutet, dass der Strom durch den Strommesswiderstand und die über dem Paar der Spannungsmesskontakte gemessene Spannung phasengleich sind. Diese Variante der Erfindung beansprucht auch Schutz für einen Messwiderstand mit nur einem einzigen Paar von Spannungsmesskontakten, sofern diese Spannungsmesskontakte an dem neutralen Punkt des Messwiderstands angeordnet sind.

In einem bevorzugten Ausführungsbeispiel der Erfindung weist der Messwiderstand nicht nur ein einziges Paar von Spannungsmesskontakten auf, die mit den Anschlussteilen des Messwiderstands verbunden sind, um den Spannungsabfall über dem Widerstandselement des Messwiderstands zu messen. Vielmehr weist der erfindungsgemäße Messwiderstand vorzugsweise mehrere Paare von Spannungsmesskontakten auf, wobei der eine Spannungsmesskontakt jedes Paars mit dem einen Anschlussteil verbunden ist, während der andere Spannungsmesskontakt jedes Paars das andere Anschlussteil kontaktiert. Die einzelnen Paare von Spannungsmesskontakten messen also jeweils den Spannungsabfall über dem Widerstandselement des Messwiderstands an unterschiedlichen räumlichen Positionen des Messwiderstands. Dadurch können die eingangs beschriebenen störenden Inhomogenitäten der Stromdichte messtechnisch kompensiert werden, indem die über dem Messwiderstand abfallende elektrische Spannung aus sämtlichen Spannungsmesswerten an den Paaren von Spannungsmesskontakten berechnet wird, beispielsweise durch eine einfache Mittelwertbildung.

Vorzugsweise sind die Paare von Spannungsmesskontakten hierbei bezüglich der Stromflussrichtung in dem Messwiderstand nebeneinander angeordnet. Bei einem plattenförmigen Messwiderstand, wie er beispielsweise aus EP 0 605 800 A1 bekannt ist, bedeutet dies, dass die einzelnen Paare von Spannungsmesskontakten quer zu dem Messwiderstand nebeneinander angeordnet sind. Bei einem Koaxialwiderstand, wie er beispielsweise aus WO 2007/068409 A1 bekannt ist, bedeutet dies dagegen vorzugsweise, dass die einzelnen Paare von Spannungsmesskontakten über den Umfang des Koaxialwiderstands verteilt angeordnet sind.

Die beiden vorstehend erwähnten Druckschriften EP 0 605 800 A1 und WO 2007/068409 A1 beschreiben jeweils einen plattenförmigen Messwiderstand bzw. einen Koaxialwiderstand, so dass auf eine detaillierte Beschreibung der konstruktiven Einzelheiten dieser Widerstandstypen verzichtet werden kann. Der Inhalt dieser Druckschriften ist deshalb der vorliegenden Beschreibung hinsichtlich des konstruktiven Aufbaus eines plattenförmigen Messwiderstands bzw. eines Koaxialwiderstands in vollem Umfang zuzurechnen.

Weiterhin ist zu erwähnen, dass die Paare der Spannungsmesskontakte vorzugsweise im Wesentlichen äquidistant verteilt angeordnet sind. Dies ist vorteilhaft, weil die Spannungsmesswerte dann ein aussagekräftiges Bild der räumlichen Stromdichteverteilung wiedergeben, so dass die Inhomogenitäten der Stromdichteverteilung messtechnisch gut kompensiert werden können.

Ferner ist zu erwähnen, dass die vorstehend erwähnten störenden Inhomogenitäten insbesondere dann relevant sind, wenn die Breite des Widerstandselements quer zur Stromflussrichtung relativ groß ist. Der erfindungsgemäße Messwiderstand ermöglicht jedoch aufgrund der Kompensation der störenden Inhomogenitäten relativ große Breiten von mehr als 5 mm, 10 mm, 20 mm, 5 mm, 100 mm oder sogar mehr als 200 mm.

Weiterhin ist zu erwähnen, dass die Anzahl der Paare von Spannungsmesskontakten vorzugsweise größer ist als 2, 4, 6 oder sogar 8, wobei eine große räumliche Dichte von Paaren von Spannungsmesskontakten eine gute messtechnische Kompensation der störenden Inhomogenitäten ermöglicht, da räumliche Schwankungen der Stromdichte in dem Messwiderstand dann besser abgebildet werden können.

Weiterhin beansprucht die Erfindung auch eine komplette Messanordnung mit dem vorstehend beschriebenen erfindungsgemäßen Messwiderstand und einer Auswertungseinheit, die mit mindestens einem Paar von Spannungsmesskontakten verbunden ist und aus dem Spannungsmesswert bzw. aus den Spannungsmesswerten die über dem Widerstandselement abfallende Spannung ermittelt, um daraus gemäß dem Ohmschen Gesetz den elektrischen Strom berechnen zu können, der durch den Messwiderstand fließt.

Ferner beansprucht die Erfindung auch Schutz für ein entsprechendes Messverfahren, wobei die Einzelheiten des Messverfahrens bereits aus der vorstehenden Beschreibung ersichtlich sind.

Ergänzend ist hierzu zu bemerken, dass die einzelnen Spannungsmesswerte an den verschiedenen Paaren von Spannungsmesskontakten vorzugsweise jeweils mit einem Gewichtungsfaktor gewichtet werden, um dann aus den gewichteten Spannungsmesswerten die über dem Messwiderstand abfallende Spannung berechnen zu können. Vor der eigentlichen Messung werden diese Gewichtungsfaktoren vorzugsweise in einem separaten Kalibrierungsvorgang ermittelt.

Zu den Gewichtungsfaktoren ist zu bemerken, dass die störenden Inhomogenitäten des Stromverlaufs in dem Widerstandselement durch einen optimalen Satz von Gewichtungsfaktoren vollständig kompensiert werden können. Allerdings hängen die störenden Inhomogenitäten des Stromverlaufs in dem Widerstandselement auch von den aktuellen Messparametern (z.B. Temperatur, Frequenz, äußeres Magnetfeld, etc.) ab. Ein optimaler Satz von Gewichtungsfaktoren ermöglicht also nur für einen entsprechenden Satz von Messparametern eine optimale Kompensation der störenden Inhomogenitäten in dem Widerstandselement. In einem Ausführungsbeispiel der Erfindung ist deshalb vorgesehen, dass die Gewichtungsfaktoren nicht bauteilspezifisch konstant vorgegeben werden, sondern in Abhängigkeit von den aktuellen Messparametern bestimmt werden. Falls also beispielsweise die Messung unter einem äußeren Magnetfeld erfolgt, so werden andere Gewichtungsfaktoren ausgewählt als wenn die Messung ohne ein äußeres Magnetfeld erfolgt. Auf diese Weise ist es möglich, die störenden Inhomogenitäten des Stromverlaufs in dem Widerstandselement weitgehend unabhängig von den äußeren Messbedingungen (z.B. Temperatur, Frequenz, Magnetfeld) zu kompensieren, indem jeweils ein Satz von Gewichtungsfaktoren ausgewählt wird, der für die aktuellen Messbedingungen optimal geeignet ist. Der optimal geeignete Satz von Gewichtungsfaktoren wird hierbei vorzugsweise im Rahmen eines Kalibrierungsvorgangs bestimmt. Im Rahmen des Kalibrierungsvorgangs wird der Messwiderstand mit vorgegebenen, bekannten Strömen bestromt, wobei jeweils die Spannungsmesswerte über den Spannungsmesskontakten gemessen werden. Hierbei werden die Messparameter (z.B. Temperatur, Frequenz, Magnetfeld) für jeden Wert der Bestromung gemessen. Auf diese Weise kann dann für jeden Betriebspunkt ein optimaler Satz von Gewichtungsfaktoren ermittelt werden. Die so ermittelten Gewichtungsfaktoren für die verschiedenen Messparameter können dann in einem mehrdimensionalen Kennfeld gespeichert und dann während des eigentlichen Messbetriebs einfach ausgelesen werden.

Es ist jedoch alternativ auch möglich, dass die optimalen Gewichtungsfaktoren nicht aus einem Kennfeld ausgelesen, sondern in Abhängigkeit von den aktuellen Messparametern analytisch bestimmt werden.

Weiterhin ist zu erwähnen, dass die einzelnen Spannungsmesswerte vorzugsweise synchron gemessen werden. Durch diese synchrone und parallele Messung einer Vielzahl von Spannungsmesswerten wird auch das Rauschen stark reduziert, was bei den meist sehr kleinen Spannungsmesswerten ein großer Vorteil ist, da hiermit die Messauflösung gesteigert werden kann.

Darüber hinaus erfolgt die Messung der einzelnen Spannungsmesswerte vorzugsweise mit einer sehr hohen Abtastrate von beispielsweise mehr als 100 Hz, 500 Hz, 1 kHz, 2 kHz oder sogar mehr als 4 kHz.

In einem bevorzugten Ausführungsbeispiel der Erfindung wird ein Mittelwert der Spannungsmesswerte an den einzelnen Paaren von Spannungsmesskontakten berechnet, wobei die einzelnen Spannungsmesswerte auch unterschiedlich gewichtet werden können.

Diese Mittelwertbildung kann wahlweise auf der Grundlage der analogen Spannungsmesswerte oder auf der Grundlage von entsprechend digitalisierten Spannungsmesswerten erfolgen.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:
- Figur 1: eine schematische Perspektivansicht eines nicht erfindungsgemäßen Strommesswiderstandes mit einer Vielzahl von Spannungsmesskontakten,
- Figur 2: ein Ausführungsbeispiel eines erfindungsgemäßen plattenförmigen Strommesswiderstandes mit nur einem Paar von Spannungsmesskontakten.

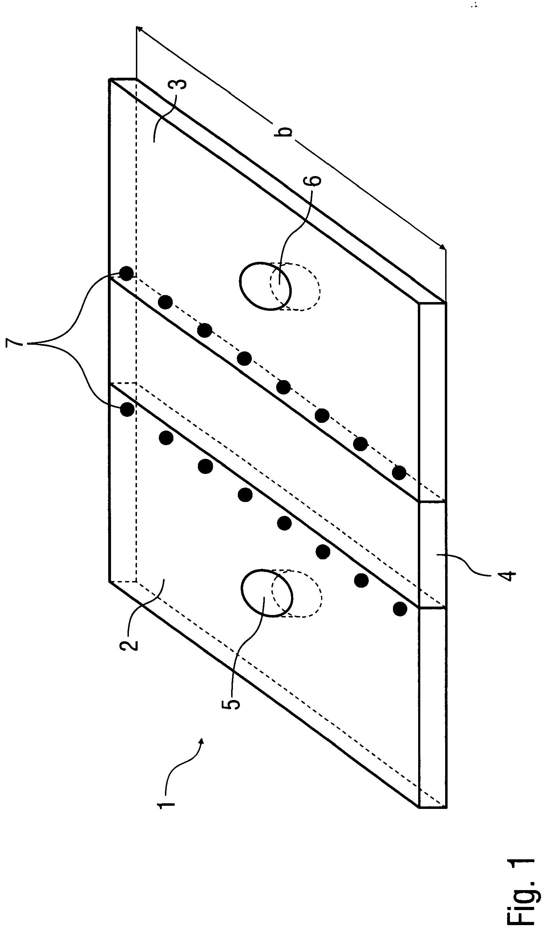

Figur 1 zeigt einen plattenförmigen Strommesswiderstand 1 zur Strommessung entsprechend der bekannten Vierleitertechnik. Der Strommesswiderstand 1 ist weitgehend herkömmlich aufgebaut, so dass ergänzend auf die Patentanmeldung EP 0 605 800 A1 verwiesen wird, deren Inhalt der vorliegenden Beschreibung deshalb in vollem Umfang zuzurechnen ist.

Der Strommesswiderstand 1 besteht im Wesentlichen aus zwei plattenförmigen Anschlussteilen aus einem Leitermaterial (z.B. Kupfer oder eine Kupferlegierung) und einem ebenfalls plattenförmigen Widerstandselement 4 aus einem niederohmigen Widerstandsmaterial (z.B. Manganin®). Der zu messende elektrische Strom wird hierbei in das Anschlussteil 2 eingeleitet, fließt dann durch das Widerstandselement 4 und verlässt den Strommesswiderstand dann über das andere Anschlussteil 3.

Zum Einleiten bzw. Ausleiten des elektrischen Stroms weisen die Anschlussteile 2, 3 jeweils eine oder mehrere Bohrungen 5, 6 auf, an denen beispielsweise Anschlusskontakte festgeschraubt werden können.

In diesem Ausführungsbeispiel weist der Strommesswiderstand 1 eine Breite b = 200 mm auf, jedoch sind auch andere Werte für die Breite b des Strommesswiderstandes 1 möglich.

Problematisch hierbei ist die Tatsache, dass die Stromdichte in dem Widerstandselement 4 nicht exakt homogen und gleichgerichtet ist, sondern über die Breite b des Strommesswiderstandes 1 schwankt, was bei den herkömmlichen Messwiderständen zu entsprechenden Messfehlern führt, da die über dem Widerstandselement 4 abfallende Spannung hierbei nur durch zwei Spannungsmesskontakte gemessen wird.

Der erfindungsgemäße Strommesswiderstand 1 weist deshalb eine Vielzahl von Paaren von Spannungsmesskontakten 7 auf, die über die Breite b des Strommesswiderstandes 1 verteilt angeordnet sind. Bei jedem der Paare der Spannungsmesskontakte 7 ist einer der Spannungsmesskontakte 7 an dem Anschlussteil 2 angebracht, während der andere Spannungsmesskontakt 7 eines jeden Paares das andere Anschlussteil 3 kontaktiert. Die einzelnen Paare von Spannungsmesskontakten 7 messen also jeweils die über dem Widerstandselement 4 abfallende elektrische Spannung an verschiedenen Stellen entlang der Breite b des Strommesswiderstandes 1.

Bei einer Messung werden dann gleichzeitig zahlreiche Spannungsmesswerte an den Spannungsmesskontakten 7 gemessen, aus denen dann beispielsweise durch eine gewichtete Mittelwertbildung ein Spannungswert abgeleitet werden kann, der von den vorstehend beschriebenen störenden Inhomogenitäten der Stromdichte in dem Widerstandselement 4 befreit ist und deshalb eine größere Genauigkeit aufweist.

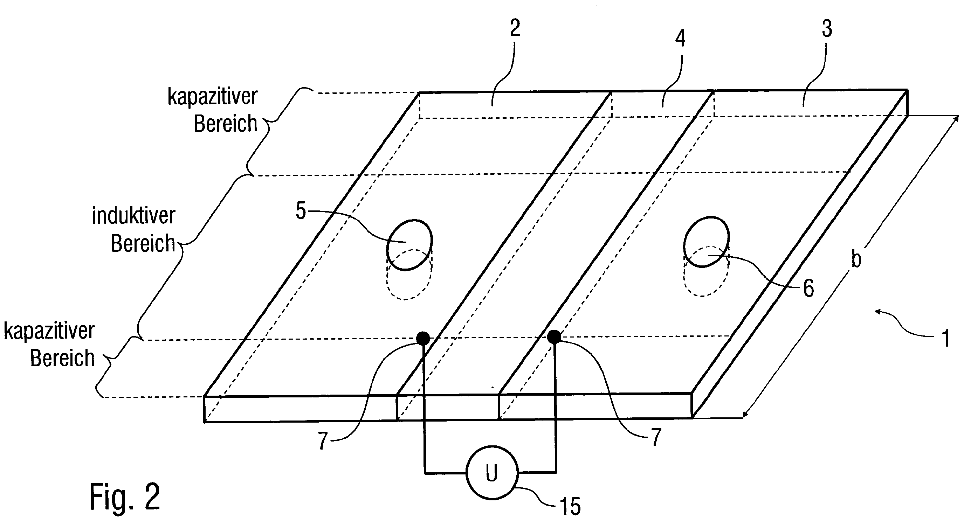

Figur 2 zeigt ein Ausführungsbeispiel eines erfindungsgemäßen Strommesswiderstandes 1, der im Wesentlichen dem herkömmlichen Strommesswiderstand 1 gemäß Figur 1 entspricht, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses erfindungsgemäßen Ausführungsbeispiels besteht darin, dass der Strommesswiderstand 1 nur ein einziges Paar von Spannungsmesskontakten 7 aufweist, die jedoch zur Vermeidung von störenden Einflüssen der Inhomogenitäten der Stromverteilung in dem Widerstandselement 4 im Bereich des neutralen Punkts 9 angeordnet sind, d.h. exakt an der Grenze zwischen dem kapazitiven Bereich und dem induktiven Bereich des Strommesswiderstandes 1. Bei einer Messung eines Spannungsmesswerts an den Spannungsmesskontakten 7 mittels einer Auswertungseinheit 15 zeigen Strom und Spannung also weder ein induktives Verhalten noch ein kapazitives Verhalten, sondern sind im Wesentlichen phasengleich.

## Patentansprüche

1. Messwiderstand (1; 10), insbesondere niederohmiger Strommesswiderstand, mit
a) einem ersten Anschlussteil (2) aus einem Leitermaterial zum Einleiten eines Stroms in den Messwiderstand (1; 10),
b) einem zweiten Anschlussteil (3) aus dem Leitermaterial zum Ausleiten des Stroms aus dem Messwiderstand (1; 10),
c) einem Widerstandselement (4; 13) aus einem Widerstandsmaterial, wobei das Widerstandselement (4; 13) in Stromrichtung zwischen den beiden Anschlussteile angeordnet ist und von dem Strom durchflossen wird,
c1) wobei sich Strom und Spannung in den seitlich außen liegenden Bereichen des Widerstandselements (4; 13) kapazitiv verhalten,
c2) während sich Strom und Spannung in einem mittleren Bereich des Widerstandselements (4; 13) im Wesentlichen induktiv verhalten, und mit
d) einem ersten Paar von Spannungsmesskontakten (7; 14) zur Messung der über dem Widerstandselement (4; 13) abfallenden Spannung, wobei der eine Spannungsmesskontakt (7) das erste Anschlussteil (2) elektrisch kontaktiert, während der andere Spannungsmesskontakt (7) das zweite Anschlussteil (3) elektrisch kontaktiert,
**dadurch gekennzeichnet,**
e) dass das erste Paar der Spannungsmesskontakte (7; 14) an einer Stelle (9) angeordnet ist, an der der Messwiderstand (1; 10) weder ein kapazitives Verhalten noch ein induktives Verhalten zeigt, so dass der durch den Messwiderstand (1; 10) fließende Strom und die Spannung über den Spannungsmesskontakten (7; 14) des ersten Paars im Wesentlichen phasengleich sind.

2. Messwiderstand (1; 10) nach Anspruch 1,
**dadurch gekennzeichnet,**
a) **dass** der Messwiderstand (1; 10) mindestens ein zweites Paar von Spannungsmesskontakten (7; 14) zur Messung der über dem Widerstandselement (4; 13) abfallenden Spannung aufweist, wobei der eine Spannungsmesskontakt (7) das erste Anschlussteil (2) elektrisch kontaktiert, während der andere Spannungsmesskontakt (7) das zweite Anschlussteil (3) elektrisch kontaktiert, und/oder
b) **dass** die Paare von Spannungsmesskontakten (7; 14) bezüglich der Stromflussrichtung in dem Messwiderstand (1; 10) nebeneinander angeordnet sind.

3. Messwiderstand (1; 10) nach Anspruch 2, **dadurch gekennzeichnet, dass** die Paare der Spannungsmesskontakte (7; 14) im Wesentlichen äquidistant verteilt angeordnet sind.

4. Messwiderstand (1; 10) nach einem der vorhergehenden Ansprüche, **dadurch gekennzeichnet, dass** das Widerstandselement (4; 13) quer zur Stromflussrichtung eine Breite (b) von mindestens 5 mm, 10 mm, 20 mm, 50 mm 100 mm oder 200 mm aufweist.

5. Messwiderstand (1; 10) nach einem der Ansprüche 2 bis 4, **dadurch gekennzeichnet, dass** die Anzahl der Paare von Spannungsmesskontakten (7; 14) größer ist als zwei, vier, sechs oder acht.

6. Messwiderstand (1; 10) nach einem der vorhergehenden Ansprüche, **dadurch gekennzeichnet,**
a) **dass** der Messwiderstand (1) plattenförmig ist oder
b) **dass** der Messwiderstand (10) ein Koaxialwiderstand ist, wobei die Paare von Spannungsmesskontakten (14) über den Umfang verteilt angeordnet sind.

7. Messwiderstand (1; 10) nach einem der Ansprüche 2 bis 6,
**dadurch gekennzeichnet,**
a) **dass** der Messwiderstand (1; 10) an mindestens einem der Paare von Spannungsmesskontakten (7; 14) ein kapazitives Verhalten zeigt, und
b) **dass** der Messwiderstand (1; 10) an mindestens einem der Paare von Spannungsmesskontakten (7; 14) ein induktives Verhalten zeigt.

8. Messanordnung mit einem Messwiderstand (1; 10) nach einem der vorhergehenden Ansprüche und einer Auswertungseinheit (15), die mit dem mindestens einen Paar von Spannungsmesskontakten (7; 14) verbunden ist und den mindestens einen Spannungsmesswert erfasst und aus dem mindestens einen Spannungsmesswert die über dem Widerstandselement (4; 13) abfallende Spannung ermittelt.

9. Messverfahren, insbesondere zur Strommessung gemäß der Vierleitertechnik, insbesondere mit einem Messwiderstand (1; 10) nach einem der vorhergehenden Ansprüche, mit den folgenden Schritten:
a) Einleiten eines zu messenden Stroms in einen Messwiderstand (1; 10), so dass der Strom durch ein Widerstandselement (4; 13) in dem Messwiderstand (1; 10) fließt,
a1) wobei sich Strom und Spannung in den seitlich außen liegenden Bereichen des Widerstandselements (4; 13) kapazitiv verhalten,
a2) während sich Strom und Spannung in einem mittleren Bereich des Widerstandselements (4; 13) im Wesentlichen induktiv verhalten,
b) Ausleiten des Stroms aus dem Messwiderstand (1; 10) und
c) Ermitteln der Spannung, die über dem Widerstandselement (4; 13) des Messwiderstands (1; 10) abfällt, wenn der Strom durch das Widerstandselement (4; 13) fließt, wobei die Spannung an einem ersten Paar von Spannungsmesskontakten (7; 14) gemessen wird,
**dadurch gekennzeichnet,**
d) dass das erste Paar der Spannungsmesskontakte (7; 14) an einer Stelle (9) angeordnet ist, an der der Messwiderstand (1; 10) weder ein kapazitives Verhalten noch ein induktives Verhalten zeigt, so dass der durch den Messwiderstand (1; 10) fließende Strom und die Spannung über den Spannungsmesskontakten (7; 14) des ersten Paars im Wesentlichen phasengleich sind.

10. Messverfahren nach Anspruch 9, **dadurch gekennzeichnet, dass** an mehreren Paaren von Spannungsmesskontakten (7; 14) jeweils Spannungsmesswerte der über dem Widerstandselement (4; 13) abfallenden Spannung gemessen werden, wobei die über dem Widerstandselement (4; 13) abfallende Spannung aus den einzelnen Spannungsmesswerten an den Paaren von Spannungsmesskontakten (7; 14) ermittelt wird,

11. Messverfahren nach Anspruch 10,
**gekennzeichnet durch** folgende Schritte:
a) Gewichten der einzelnen Spannungsmesswerte jeweils mit einem Gewichtungsfaktor, und
b) Bestimmen der über dem Widerstandselement (4; 13) abfallenden Spannung aus den gewichteten Spannungsmesswerten, und/oder
c) Kalibrieren der Gewichtungsfaktoren in einem Kalibrierungsvorgang, und/oder
d) Ermitteln von mindestens einem Messparameter, der einen Einfluss hat auf Inhomogenitäten des Stroms in dem Widerstandselement (4; 13), und
e) Bestimmen der Gewichtungsfaktoren in Abhängigkeit von dem mindestens einen Messparameter.

12. Messverfahren nach Anspruch 11, **dadurch gekennzeichnet, dass** der Messparameter mindestens eine der folgenden Größen umfasst:
a) Frequenz des Stroms,
b) Temperatur der Umgebung oder des Messwiderstands,
c) Größe und Richtung eines äußeren Magnetfelds, in dem die Messung erfolgt,
d) Strom durch den Messwiderstand,
e) Spannung über den Spannungsmesskontakten.

13. Messverfahren nach einem der Ansprüche 9 bis 12,
**dadurch gekennzeichnet,**
a) **dass** die Spannungsmesswerte an den einzelnen Paaren der Spannungsmesskontakte (7; 14) synchron gemessen werden, und/oder
b) **dass** Spannungsmesswerte an den einzelnen Paaren der Spannungsmesskontakte (7; 14) mit einer Abtastrate von mindestens 100 Hz, 500 Hz, 1 kHz, 2 kHz oder mindestens 4 kHz gemessen werden.

14. Messverfahren nach einem der Ansprüche 10 bis 13,
**gekennzeichnet durch** folgende Schritte:
a) Berechnen eines einfachen oder gewichteten Mittelwerts der Spannungsmesswerte,
b) Berechnen der über dem Widerstandselement (4; 13) abfallenden Spannung aus dem Mittelwert der Spannungsmesswerte.

15. Messverfahren nach einem der Ansprüche 10 bis 14,
**dadurch gekennzeichnet,**
a) **dass** die analogen Spannungsmesswerte in digitalisierte Spannungsmesswerte umgewandelt werden, und/oder
b) **dass** die einfache oder gewichtete Mittelwertbildung auf der Grundlage der analogen Spannungsmesswerte oder auf der Grundlage der digitalisierten Spannungsmesswerte erfolgt.

## Claims

1. A measuring resistor (1; 10), in particular a low-resistance current sense resistor, comprising
a) a first connection part (2) made of a conductive material for conducting a current into the measuring resistor (1; 10),
b) a second connection part (3) made of a conductive material for conducting the current out of the measuring resistor (1; 10),
c) a resistor element (4; 13) made of a resistive material, which resistor element (4; 13) is arranged in the current direction between the two connection parts, and through which resistive material the current flows,
c1) wherein current and voltage exhibit a capacitive behavior in the lateral outer areas of the resistor element (4; 13),
c2) while current and voltage exhibit an inductive behavior in a central area of the resistor element (4; 13),
d) a first pair of voltage-measuring contacts (7; 14) for measuring the voltage drop across the resistor element (4; 13), wherein the one voltage-measuring contact (7) is electrically connected to the first connection part (2), whereas the other voltage-measuring contact (7) is electrically connected to the second connection part (3),
**characterized in that**
e) the first pair of voltage-measuring contacts (7; 14) is arranged at a position (9) at which the measuring resistor (1; 10) exhibits neither capacitive nor inductive behavior, and therefore the current flowing through the measuring resistor (1; 10) and the voltage across the voltage-measuring contacts (7; 14) of the first pair are substantially in phase.

2. The measuring resistor (1; 10) according to claim 1,
**characterized in that**
a) the measuring resistor (1; 10) comprises at least one second pair of voltage-measuring contacts (7; 14) for measuring the voltage drop across the resistor element (4; 13), wherein the one voltage-measuring contact (7) is electrically connected to the first connection part (2), whereas the other voltage-measuring contact (7) is electrically connected to the second connection part (3), and/or
b) the pairs of voltage-measuring contacts (7; 14) are arranged in the measuring resistor (1; 10) side by side with respect to the direction of current flow.

3. The measuring resistor (1; 10) according to claim 2,
**characterized in that** the pairs of voltage-measuring contacts (7; 14) are arranged in a substantially equidistant distribution.

4. The measuring resistor (1; 10) according to any of the preceding claims, **characterized in that** the resistor element (4; 14) has a width (b) across the direction of current flow of at least 5 mm, 10 mm, 20 mm, 50 mm, 100 mm or 200 mm.

5. The measuring resistor (1; 10) according to any of claims 2 to 4, **characterized in that** the number of pairs of voltage-measuring contacts (7; 14) is greater than two, four, six or eight.

6. The measuring resistor (1; 10) according to any of the preceding claims, **characterized in that**
a) the measuring resistor (1) is plate-shaped, or
b) the measuring resistor (10) is a coaxial resistor, wherein the pairs of voltage-measuring contacts (14) are distributed around the circumference.

7. The measuring resistor (1; 10) according to any of claims 2 to 6, **characterized in that**
a) the measuring resistor (1; 10) exhibits a capacitive behavior at least at one of the pairs of voltage-measuring contacts (7; 14), and
b) the measuring resistor (1; 10) exhibits an inductive behavior at least at one of the pairs of voltage-measuring contacts (7; 14).

8. A measurement assembly comprising a measuring resistor (1; 10) according to any of the preceding claims and comprising an evaluation unit (15), which is connected to the at least one pair of voltage-measuring contacts (7; 14) and acquires the measured voltage values, and determines from the measured voltage values the voltage drop across the resistor element (4; 13).

9. A measuring method, in particular for measuring current by means of the four-wire technique, in particular using a measuring resistor (1; 10) according to any of the preceding claims, comprising the following steps:
a) conducting a current to be measured into a measuring resistor (1; 10), so that the current flows through a resistor element (4; 13) in the measuring resistor (1; 10),
a1) wherein current and voltage exhibit a capacitive behavior in the lateral outer areas of the resistor element (4; 13),
a2) while current and voltage exhibit an inductive behavior in a central area of the resistor element (4; 13),
b) conducting the current out of the measuring resistor (1; 10), and
c) determining the voltage drop across the resistor element (4; 13) of the measuring resistor (1; 10) when the current is flowing through the resistor element (4; 13), which voltage is measured at a first pair of voltage-measuring contacts (7; 14),
**characterized in that**
d) the first pair of voltage-measuring contacts (7; 14) is arranged at a position (9) at which the measuring resistor (1; 10) exhibits neither capacitive nor inductive behavior, and therefore the current flowing through the measuring resistor (1; 10) and the voltage across the voltage-measuring contacts (7; 14) of the first pair are substantially in phase.

10. The measuring method according to claim 9,
**characterized in that** measured voltage values of the voltage drop across the resistor element (4; 13) are measured at each of a plurality of pairs of voltage-measuring contacts (7; 14), wherein the voltage drop across the resistor element (4; 13) is determined from the individual measured voltage values at the pairs of voltage-measuring contacts (7; 14), or

11. The measuring method according to claim 10,
**characterized by** the following steps:
a) weighting each of the individual measured voltage values with a weighting factor, and
b) determining the voltage drop across the resistor element (4; 13) from the weighted measured voltage values, and/or
c) calibrating the weighting factors in a calibration process.

12. The measuring method according to claim 11,
**characterized in that** the measurement parameter comprises at least one of the following variables:
a) frequency of the current,
b) ambient temperature or temperature of the measuring resistor,
c) magnitude and direction of an external magnetic field in which the measurement is taking place,
d) current through the measuring resistor,
e) voltage across the voltage-measuring contacts.

13. The measuring method according to any of claims 9 to 12, **characterized in that**
a) the measured voltage values are measured synchronously at the individual pairs of voltage-measuring contacts (7; 14).
b) the measured voltage values are measured at the individual pairs of voltage-measuring contacts (7; 14) at a sampling rate of at least 100 Hz, 500 Hz, 1 kHz, 2 kHz or at least 4 kHz.

14. The measuring method according to any of claims 10 to 13, **characterized by** the following steps:
a) calculating a simple or weighted average of the measured voltage values,
b) calculating the voltage drop across the resistor element (4; 13) from the average of the measured voltage values.

15. The measuring method according to any of claims 10 to 14, **characterized in that**
a) the analog measured voltage values are converted into digitized measured voltage values, and/or
b) the simple or weighted averaging is performed on the basis of the analog measured voltage values or on the basis of the digitized measured voltage values.

## Revendications

1. Résistance de mesure (1 ; 10), en particulier résistance de mesure de courant à faible valeur ohmique, comprenant
a) une première partie de raccordement (2) composée d'un matériau conducteur servant à introduire un courant dans la résistance de mesure (1 ; 10) ;
b) une deuxième partie de raccordement (3) composée du matériau conducteur servant à évacuer le courant hors de la résistance de mesure (1 ; 10),
c) un élément de résistance (4 ; 13) composé d'un matériau de résistance, dans laquelle l'élément de résistance (4 ; 13) est disposé dans la direction de courant entre les deux parties de raccordement et est traversé par le courant ;
c1) dans laquelle le courant et la tension se comportent de manière capacitive dans les zones situées latéralement à l'extérieur de l'élément de résistance (4 ; 13),
c2) tandis que le courant et la tension se comportent sensiblement de manière inductive dans une zone centrale de l'élément de résistance (4 ; 13), et comprenant
d) une première paire de contacts de mesure de tension (7 ; 14) servant à mesurer la baisse de tension sur l'élément de résistance (4 ; 13), dans laquelle un premier contact de mesure de tension (7) établit un contact électrique avec la première partie de raccordement (2), tandis que l'autre contact de mesure de tension (7) établit un contact électrique avec la deuxième partie de raccordement (3),
**caractérisée en ce**
e) que la première paire des contacts de mesure de tension (7 ; 14) est disposée en un emplacement (9), au niveau duquel la résistance de mesure (1 ; 10) n'affiche ni un comportement capacitif ni un comportement inductif de sorte que le courant s'écoulant à travers la résistance de mesure (1 ; 10) et la tension sont sensiblement en phase sur les contacts de mesure de tension (7 ; 14) de la première paire.

2. Résistance de mesure (1 ; 10) selon la revendication 1,
**caractérisée en ce**
a) **que** la résistance de mesure (1 ; 10) présente au moins une deuxième paire de contacts de mesure de tension (7 ; 14) servant à mesurer la baisse de tension sur l'élément de résistance (4 ; 13), dans laquelle un contact de mesure de tension (7) établit un contact électrique avec la première partie de raccordement (2), tandis que l'autre contact de mesure de tension (7) établit un contact électrique avec la deuxième partie de raccordement (3), et/ou
b) **que** les paires de contacts de mesure de tension (7 ; 14) sont disposées les unes à côté des autres par rapport à la direction de flux de courant dans la résistance de mesure (1 ; 10).

3. Résistance de mesure (1 ; 10) selon la revendication 2, **caractérisée en ce que** les paires des contacts de mesure de tension (7 ; 14) sont disposées selon une répartition sensiblement équidistante.

4. Résistance de mesure (1 ; 10) selon l'une quelconque des revendications précédentes, **caractérisée en ce que** l'élément de résistance (4 ; 13) présente de manière transversale par rapport à la direction de flux de courant une largeur (b) d'au moins 5 mm, 10 mm, 20 mm, 50 mm, 100 mm ou 200 mm.

5. Résistance de mesure (1 ; 10) selon l'une quelconque des revendications 2 à 4, **caractérisée en ce que** le nombre des paires de contacts de mesure de tension (7 ; 14) est supérieur à deux, quatre, six ou huit.

6. Résistance de mesure (1 ; 10) selon l'une quelconque des revendications précédentes, **caractérisée en ce**
a) **que** la résistance de mesure (1) est en forme de plaque, ou
b) **que** la résistance de mesure (10) est une résistance coaxiale, dans laquelle les paires de contacts de mesure de tension (14) sont disposées de manière répartie sur la périphérie.

7. Résistance de mesure (1 ; 10) selon l'une quelconque des revendications 2 à 6,
**caractérisée en ce**
a) **que** la résistance de mesure (1 ; 10) affiche, au niveau d'au moins une des paires de contacts de mesure de tension (7 ; 14), un comportement capacitif, et
b) **que** la résistance de mesure (1 ; 10) affiche, au niveau d'au moins une des paires de contacts de mesure de tension (7 ; 14), un comportement inductif.

8. Ensemble de mesure comprenant une résistance de mesure (1 ; 10) selon l'une quelconque des revendications précédentes et une unité d'évaluation (15), qui est reliée à l'au moins une paire de contacts de mesure de tension (7 ; 14) et détecte l'au moins une valeur de mesure de tension et détermine, à partir de l'au moins une valeur de mesure de tension, la baisse de tension sur l'élément de résistance (4 ; 13).

9. Procédé de mesure, en particulier servant à la mesure de courant selon la technique quatre fils, en particulier avec une résistance de mesure (1 ; 10) selon l'une quelconque des revendications précédentes, comprenant les étapes suivantes consistant à :
a) introduire un courant à mesurer dans une résistance de mesure (1 ; 10) de sorte que le courant s'écoule dans la résistance de mesure (1 ; 10) par un élément de résistance (4 ; 13),
a1) dans laquelle le courant et la tension se comportent de manière capacitive dans les zones situées latéralement à l'extérieur de l'élément de résistance (4 ; 13),
a2) tandis que le courant et la tension se comportent sensiblement de manière inductive dans une zone centrale de l'élément de résistance (4 ; 13) ;
b) évacuer le courant hors de la résistance de mesure (1 ; 10) ; et
c) déterminer la tension, qui baisse sur l'élément de résistance (4 ; 13) de la résistance de mesure (1 ; 10) quand le courant s'écoule à travers l'élément de résistance (4 ; 13), dans laquelle la tension est mesurée sur une première paire de contacts de mesure de tension (7 ; 14),
caractérisé en ce
d) que la première paire des contacts de mesure de tension (7 ; 14) est disposée en un emplacement (9), au niveau duquel la résistance de mesure (1 ; 10) n'affiche ni un comportement capacitif ni un comportement inductif si bien que le courant s'écoulant à travers la résistance de mesure (1 ; 10) et la tension sont sensiblement en phase sur les contacts de mesure de tension (7 ; 14) de la première paire.

10. Procédé de mesure selon la revendication 9, **caractérisé en ce que** respectivement des valeurs de mesure de tension de la baisse de tension sur l'élément de résistance (4 ; 13) sont mesurées sur plusieurs paires de contacts de mesure de tension (7 ; 14), dans lequel la baisse de tension sur l'élément de résistance (4 ; 13) est déterminée à partir des diverses valeurs de mesure de tension sur les paires de contacts de mesure de tension (7 ; 14).

11. Procédé de mesure selon la revendication 10,
**caractérisé par** les étapes suivantes consistant à :
a) pondérer les diverses valeurs de mesure de tension respectivement avec un facteur de pondération ; et
b) définir la baisse de tension sur l'élément de résistance (4 ; 13) à partir des valeurs de mesure de tension pondérées ; et/ou
c) étalonner les facteurs de pondération lors d'une opération d'étalonnage ; et/ou
d) déterminer au moins un paramètre de mesure, qui a une incidence sur des inhomogénéités du courant dans l'élément de résistance (4 ; 13) ; et
e) définir les facteurs de pondération en fonction de l'au moins un paramètre de mesure.

12. Procédé de mesure selon la revendication 11,
**caractérisé en ce que** le paramètre de mesure comprend au moins une des grandeurs qui suivent :
a) la fréquence du courant ;
b) la température de l'environnement ou de la résistance de mesure ;
c) la grandeur et la direction d'un champ magnétique extérieur, dans lequel la mesure est effectuée ;
d) le courant à travers la résistance de mesure ;
e) la tension sur les contacts de mesure de tension.

13. Procédé de mesure selon l'une quelconque des revendications 9 à 12,
**caractérisé en ce**
a) **que** les valeurs de mesure de tension sont mesurées de manière synchrone sur les diverses paires des contacts de mesure de tension (7 ; 14) ; et/ou
b) **que** des valeurs de mesure de tension sont mesurées sur les diverses paires des contacts de mesure de tension (7 ; 14) à un taux de balayage d'au moins 100 Hz, 500 Hz, 1 kHz, 2 kHz ou d'au moins 4 kHz.

14. Procédé de mesure selon l'une quelconque des revendications 10 à 13,
**caractérisé par** les étapes suivantes consistant à :
a) calculer une valeur moyenne simple ou pondérée des valeurs de mesure de tension ;
b) calculer la baisse de tension sur l'élément de résistance (4 ; 13) à partir de la valeur moyenne des valeurs de tension.

15. Procédé de mesure selon l'une quelconque des revendications 10 à 14,
**caractérisé en ce**
a) **que** les valeurs de mesure de tension analogiques sont converties en des valeurs de mesure de tension numériques, et/ou
b) **que** l'obtention de valeur moyenne simple ou pondérée est effectuée sur la base des valeurs de mesure de tension analogiques ou sur la base des valeurs de mesure de tension numériques.
